# FASCICULE DE BREVET EUROPEEN

(11) **EP 3 830 313 B1**
(45) Date de publication et mention de la délivrance du brevet: **25.05.2022**
(21) Numéro de dépôt: 19742800.6
(22) Date de dépôt: 30.07.2019
(51) Int. Cl.: C23C 16/455, B33Y 80/00, H01L 29/49, H01L 21/02

(54) **TETE ET SYSTEME COMPACTS DE DEPOT EN PHASE VAPEUR**
KOMPAKTER KOPF UND KOMPAKTES SYSTEM ZUR DAMPFABSCHEIDUNG
COMPACT HEAD AND COMPACT SYSTEM FOR VAPOR DEPOSITION

(30) Priorité: 30.07.2018 FR 1857072
(43) Date de publication de la demande: 09.06.2021
(73) Titulaire: Centre national de la recherche scientifique, 75016 Paris (FR)
(72) Inventeur: MUNOZ-ROJAS, David, 38016 GRENOBLE CEDEX 1 (FR)
(74) Mandataire: Marks & Clerk France
(86) Numéro de dépôt international: PCT/EP2019/070450
(87) Numéro de publication internationale: WO 2020/025593

(56) Documents cités:
- US-A1- 2009 081 886
- US-A1- 2017 204 989
- US-A1- 2017 372 923

## Description

L'invention porte sur une tête de dépôt de couches minces en phase vapeur, et plus particulièrement d'une tête de dépôt adaptée à la mise en œuvre de la technique SALD - dépôt de couches atomiques spatial (de l'anglais « Spatial Atomic Layer Déposition »). L'invention porte également sur un système de dépôt de couches minces comprenant une telle tête.

Le dépôt de couches atomiques (ALD, de l'anglais « Atomic Layer Déposition ») est une technique de dépôt chimique en phase vapeur (CVD, de l'anglais « Chemical Vapor Déposition ») mise au point dans les années 1960-70 qui offre la possibilité unique de dépôt de couches minces de haute qualité à basse température, avec contrôle d'épaisseur précise, une uniformité exceptionnelle et une excellente couverture même en présence de marches ayant un rapport d'aspect important. Cela est dû à la nature spontanément auto-limitée de la croissance par ALD, qui s'effectue directement et de façon sélective sur la surface de l'échantillon lors de l'exposition séquentielle de différents précurseurs transportés par des flux de gaz inerte (typiquement N₂ ou Ar). Ainsi, tandis que dans les techniques traditionnelles de dépôt chimique en phase vapeur les précurseurs sont injectés en même temps réagissent sur le substrat par activation thermique ou plasma, dans le cas de l'ALD les précurseurs sont injectés par des impulsions consécutives, séparées dans le temps, permettant ainsi la surface nature sélective et spontanément résolutive de la technique.

Depuis les années 1990, l'ALD est devenue la technique de choix dans les industries des semi-conducteurs et des écrans de grandes dimensions. Plus tard, l'avènement des nanosciences et des nanotechnologies a élargi l'utilisation de l'ALD aux laboratoires de recherche.

Malgré ses atouts uniques, l'ALD présente deux inconvénients majeurs qui ont limité son application industrielle: la lenteur du dépôt et la nécessité d'opérer sous vide. En conséquence, l'ALD est aujourd'hui uniquement utilisé dans les industries où aucune autre technique n'est disponible.

L'ALD spatial (SALD) apporte une solution au problème de la lenteur de l'ALD « conventionnel ». Cette technique, initialement proposée par T. S. Suntola et al. dans le brevet US 4,389,973, consiste à séparer les précurseurs dans l'espace plutôt que dans le temps. Ainsi, dans le SALD, les précurseurs sont délivrés en permanence en correspondance de portions différentes de la surface du substrat, séparées par une zone de gaz inerte, tandis que l'échantillon se déplace de l'emplacement d'un précurseur à l'autre en passant par la zone de gaz inerte. Cela permet d'augmenter le taux de dépôt jusqu'à deux ordres de grandeur. Par ailleurs il a été démontré qu'en agençant la tête de dépôt SALD à proximité immédiate (100 µm ou moins) de la surface de dépôt et en l'équipant de d'ouvertures d'aspiration des gaz, il est possible d'opérer à pression ambiante, et donc en dehors d'une enceinte à vide. On parle alors de SALD à pression ambiante (AP-SALD). Voir par exemple US 2009/0217878 et US 2009/081886.

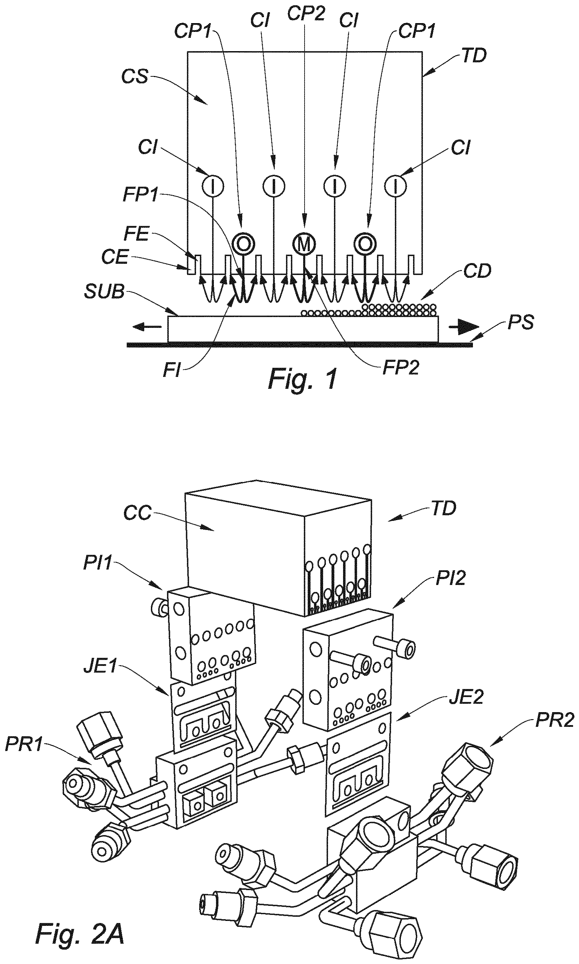

La figure 1 est une illustration schématique du principe du AP-SALD. La tête de dépôt TD est parcourue par des conduits Cl qui transportent un gaz inerte I, tel de l'azote N₂ ou de l'argon Ar ; des conduits CP1 transportant un gaz chargé en un premier précurseur, par exemple un oxydant O tel de la vapeur d'eau (H₂O) ; des conduits (en fait, un seul sur la figure 1) CP2 transportant un gaz chargé un deuxième précurseur, par exemple un composé organométallique M tel que Al(CH₃)₃, ainsi que des conduits d'évacuation CE reliés à une pompe. Les différents conduits débouchent dans des fentes respectives (FP1 pour le premier précurseur, FP2 pour le deuxième précurseur, PI pour le gaz inerte, FE pour l'évacuation) ménagées dans une face de la tâte de dépôt. Les fentes sont aménagées de telle sorte que :
- une fente reliée au conduit Cl est interposée entre deux fentes reliées à des conduits CP1, CP2 transportant des précurseurs différents, et entre ces fentes et chaque bord latéral de la tête ;
- une fente reliée à un conduit d'évacuation est interposée entre deux fentes reliées à d'autres conduits.

Les écoulements des gaz sont représentés par des flèches. On peut constater que le gaz inerte forme des « barrières » qui séparent les écoulements de gaz contenant des précurseurs entre eux et de l'air ambiant. Un substrat SUB, porté par un support ou plateau PS, est agencé en face et à une faible distance (<100 µm, par exemple 50 µm) des fentes, le plateau étant animé d'un mouvement oscillatoire parallèle à la face de la tête qui porte les fentes. La réaction successive des molécules des deux précurseurs entre elles et avec la surface du substrat conduit à la formation d'une couche mince déposée CD. Dans le cas où les précurseurs sont H₂O et Al(CH₃)₃, la couche CD est en Al₂O₃.

Des variantes sont possibles, par exemple le nombre de précurseurs peut être supérieur à deux.

Une présentation plus détaillée de la technique AP-SALD et de ses applications peut être trouvée dans l'article de David Muñoz-Rojas et Judith MacManus Driscoll « Spatial atmospheric atomic layer deposition : a new laboratory and industrial tool for low-cost photovoltaics », Material Horizons 2014, vol. 1, no 3, p. 314-320.

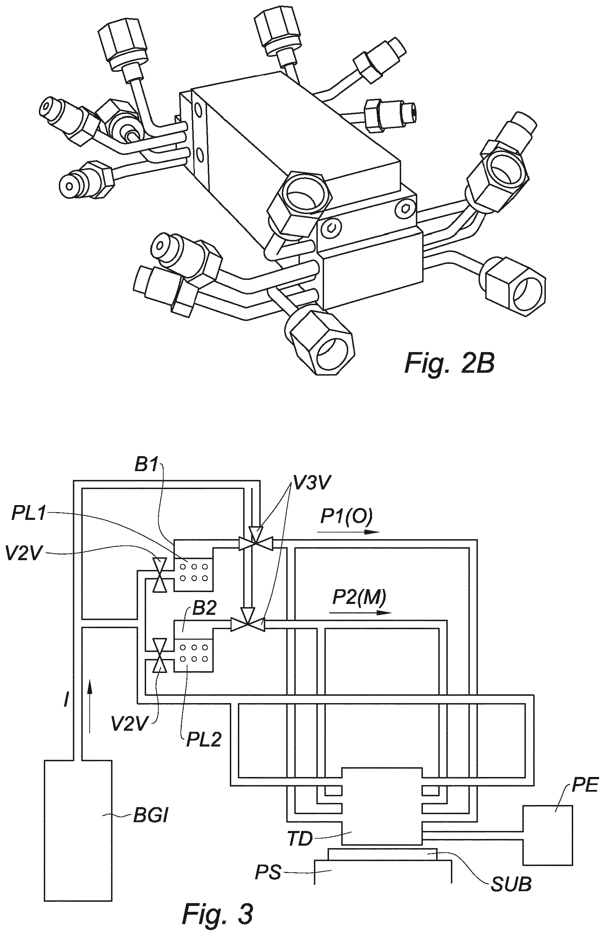

La technique AP-SALD constitue une amélioration importante de l'ALD classique. Elle demeure néanmoins relativement complexe et onéreuse. Dans certains cas on a recours à des chambres de réaction fermées, similaires à celles utilisées en ALD et CVD conventionnels. Dans d'autres cas, comme celui décrit par le document US 2009/0217878 précité, le dépôt s'effectue à l'air libre. Dans ce dernier cas, la tête de dépôt est une structure métallique de petites dimensions (par exemple de l'ordre de 40 cm³) mais présentant une structure complexe, comprenant au moins quatre réseaux de distribution de gaz indépendants (deux pour les flux gazeux transportant les précurseurs, un pour le gaz inerte de séparation, un pour l'évacuation des gaz), ainsi que des raccordements extérieurs à des conduits d'amenée ou aspiration des gaz. Cette tête est constituée de plusieurs parties, qui doivent être fabriquées, polies, assemblées et soudées avec une grande précision. La figure 2A en montre une vue éclatée d'un exemple de tête de dépôt AP-SALD « à proximité immédiate », et la figure 2B une vue assemblée de la même pièce. La fabrication d'une telle tête est longue et coûteuse.

La tête des figures 2A et 2B comprend un corps central CC à l'intérieur duquel sont creusés, par usinage, les conduits décrits plus haut en référence à la figure 1, et dont la face inférieure porte les fentes. De part et d'autre de ce corps central sont agencés deux pièces d'injection PI1, PI2, dans lesquelles sont creusés des prolongements des conduits, mais sans les fentes. Ces pièces d'injection, soudées au corps central, sont connectées, par des vis et par l'intermédiaire de joints d'étanchéité JE1, JE2, à des pièces de raccordement PR1, PR2 qui permettent de relier les conduits, par l'intermédiaire de tuyaux non représentés, à des bulleurs, des sources de gaz inertes et le cas échéant à une ou plusieurs pompes. L'utilisation de pompes pour évacuer les gaz n'est pas toujours nécessaire : le confinement par la surface du substrat peut suffire pour forcer les gaz à remonter à travers les fentes d'évacuation. Les bulleurs sont des récipients contenant les précurseurs à l'état liquide dans lesquels un gaz inerte barbote ; le gaz en ressort chargé en précurseurs, prêt pour être amené à la tête de dépôt (dans d'autres cas, le gaz ne barbote pas, mais passe simplement au-dessus du précurseur, qui peut dans ce cas être solide ; l'utilisation du terme « bulleur » relève alors d'un abus de langage). Cette dernière reçoit également du gaz inerte « pur » qui, comme cela a été expliqué plus haut, sert à séparer les régions de dépôt des différents précurseurs. La pompe sert à l'évacuation des gaz. Cela est représenté sur la figure 3. Sur cette figure BGI représente la bouteille qui fournit le gaz inerte I, B1 et B2 les bulleurs B1 et B2 contenant des précurseurs, ici à l'état liquide PL1, PL2, et PE la pompe permettant l'aspiration et l'évacuation du gaz. Le gaz inerte I parvient à la tête de dépôt, par des tuyaux distincts, à la fois directement et après avoir barboté dans les bulleurs ; on remarque, dans la partie supérieure de la figure, un conduit qui amène du gaz inerte pour diluer les flux gazeux sortant des bulleurs ; ce conduit est également utilisé pour les opérations de purge. Des vannes permettent d'isoler les bulleurs, afin de permettre leur remplacement et la purge des tuyaux. Plus précisément, des vannes à deux voies V2V sont agencées à l'entrée de chaque bulleur, et des vannes à trois voies V3V contrôlent la dilution et permettent la purge.

La référence P1 désigne le gaz inerte chargé du premier précurseur (« O » sur la figure 1) et P2 désigne le gaz inerte chargé du deuxième précurseur (« M » sur la figure 1). Dans le système représenté sur la figure, une seule évacuation est prévue ; cependant, pour éviter des réactions chimiques indésirables, il peut être préférable d'évacuer séparément - au moyen de conduits, tuyaux et pompes distincts - les gaz ; cela permet notamment de les analyser séparément, les recycler ou les éliminer de manière sûre.

Or, les tuyaux qui amènent les gaz chargés en molécules de précurseurs doivent être saturés en précurseurs avant le début des opérations de dépôt proprement dites, puis être purgés avant de changer de précurseurs pour déposer de nouveaux matériaux, ce qui prend beaucoup de temps et entraine un gaspillage de grandes quantités de précurseurs ainsi qu'un risque de contamination croisée. En outre, il est difficile de déplacer la tête fixée aux tuyaux ; il est donc généralement préférable de la maintenir fixe et de déplacer le substrat de dépôt. Cela limite le choix des substrats utilisables ; il est par exemple difficile, voire impossible, d'effectuer un dépôt de couches atomiques sur une portion d'un objet de grandes dimensions.

L'invention vise à résoudre, en tout ou en partie, les problèmes précités et à rendre plus flexible, plus rapide et moins onéreuse la mise en œuvre de la technique AP-SALD.

Conformément à un aspect de l'invention, cela est obtenu par l'utilisation d'une tête de dépôt réalisée en une seule pièce par fabrication additive (« impression 3D »). Cela permet à la fois une réduction des coûts, un plus large choix des matériaux utilisables (en fonction des précurseurs à délivrer, on peut réaliser une tête de dépôt en métal, mais aussi en céramique voire en matière plastique), une plus grande liberté dans les formes réalisables et une plus grande miniaturisation. Il devient ainsi possible de fabriquer « à la demande » une tête de dépôt optimisé pour un processus particulier et pour la fabrication d'une couche ou structure multicouches particulière.

Les documents US 2017/204989 et US 2017/372923 divulguent des réseaux de distribution de gaz réalisés par fabrication additive.

Conformément à un autre aspect de l'invention, le bulleurs peuvent être rapprochés de la tête de dépôt et montés avec elle sur un chariot mobile. Ainsi, ce n'est plus le substrat qui se déplace au-dessous d'une tête de dépôt fixe, mais le chariot portant la tête de dépôt et les bulleurs - de préférence miniaturisés (moins de 10 ml, par exemple 1 ou 2 ml) - qui se déplace au-dessus du substrat, qui peut ainsi être un objet de grandes dimensions ou, plus généralement, inamovible. Le raccourcissement des conduits d'amenée des gaz réduit le gaspillage de précurseurs et réduit la durée la phase de saturation et purge. En outre, tout l'ensemble peut être chauffé à une température homogène, ce qui est utile en cas d'utilisation de précurseurs peu volatiles. Ces bulleurs miniaturisés, par exemple réalisés par fabrication additive, peuvent être fournis déjà pré-rempli des précurseurs, et former ainsi un « consommable » semblable à une cartouche d'encre d'une imprimante.

Selon l'invention, les bulleurs sont réalisés d'une seule pièce avec la tête de dépôt par fabrication additive. L'ensemble formé par la tête de dépôt et les bulleurs, qui peuvent d'ailleurs être fournis déjà pré-rempli des précurseurs et former un « consommable », ce qui permet, dans certains cas, de se passer de la phase de purge et donc de simplifier la réalisation de structures complexes nécessitant plusieurs dépôts de couches minces de compositions différentes.

L'invention est définie par le jeu de revendications afférent.

Un objet de la demande est donc une tête de dépôt chimique en phase vapeur comprenant un corps solide comportant :
- au moins une première ouverture pour recevoir un premier flux gazeux en entrée transportant un premier précurseur, une deuxième ouverture pour recevoir un deuxième flux gazeux en entrée transportant un deuxième précurseur, une troisième ouverture pour recevoir un troisième flux gazeux inerte en entrée et une quatrième ouverture d'évacuation d'un quatrième flux gazeux ;
- une face de sortie portant une pluralité d'orifice ; et
- un réseau de conduits de distribution, ménagé à l'intérieur du corps solide, reliant chaque ouverture à au moins un desdits orifices ;
   dans laquelle chaque orifice relié à la première ouverture est séparé du ou de chaque plus proche orifice relié à la deuxième ouverture par au moins un orifice relié à la troisième ouverture et par deux orifice reliés à la quatrième ouverture, agencés de part et d'autre de l'orifice relié à la troisième ouverture ;
   caractérisée en ce que le corps solide est réalisé en une seule pièce par fabrication additive, le réseau de conduits de distribution étant formé par des cavités ménagées dans ladite pièce.

Selon des modes de réalisation particuliers d'une telle tête de dépôt :
- Les orifices peuvent être des fentes rectilignes et parallèles entre elles.
- Au moins une fente reliée à la première et au moins une fente reliée à la deuxième ouverture peuvent présenter une longueur moindre que les fentes reliées à la troisième et à la quatrième ouverture et être décalées l'une par rapport à l'autre dans le sens de la longueur.
- Les orifices peuvent former des courbes fermées concentriques, et préférentiellement des cercles concentriques.

Selon l'invention, la tête comprend également au moins un premier et un deuxième réservoir, reliés respectivement à la première et à la deuxième ouverture par des conduits de sortie respectifs, chaque dit réservoir comprenant un volume creux susceptible de contenir un précurseur à l'état liquide ou solide et un conduit d'entrée agencé de telle sorte qu'un flux gazeux injecté dans le conduit d'entrée entre en contact avec le précurseur avant de parvenir au conduit de sortie respectif, le premier et le deuxième réservoirs, ainsi que les conduits d'entrée et de sortie, étant réalisés d'une seule pièce avec le corps solide par fabrication additive.

Au moins un dit réservoir peut être un bulleur dont le volume creux est destiné à contenir un précurseur à l'état liquide, le conduit d'entrée et le conduit de sortie étant agencés de telle sorte que le flux gazeux injecté dans le conduit d'entrée barbote à travers le liquide avant de parvenir au conduit de sortie.

Le volume creux dudit ou de chaque bulleur peut contenir une structure configurée pour allonger le trajet parcouru par des bulles de gaz entre le conduit d'entrée et le conduit de sortie.

Un autre objet de l'invention est un système de dépôt en phase vapeur comprenant une telle tête ainsi qu'un chariot portant ladite tête et permettant de la déplacer au-dessus d'un substrat.

Encore un autre objet de l'invention est un procédé de dépôt d'au moins une couche mince, ou d'un dispositif à couches minces, sur un substrat comprenant :
- la conception d'un processus de dépôt en phase vapeur adapté à la réalisation de ladite couche ou dudit dispositif ;
- la conception d'une telle tête de dépôt, spécialement adaptée à la mise en œuvre d'un tel processus ;
- la réalisation de ladite tête de dépôt par fabrication additive ; et
- l'utilisation de ladite tête pour la mise en œuvre dudit processus.

Ledit processus de dépôt est avantageusement effectué de manière spatialement sélective sur le substrat.

D'autres caractéristiques, détails et avantages de l'invention ressortiront à la lecture de la description faite en référence aux dessins annexés donnés à titre d'exemple et qui représentent, respectivement :
- la figure 1, déjà décrite, le principe de la technique AP-SALD ;
- les figures 2A et 2B, déjà décrites, une tête de dépôt AP-SALD de type conventionnel ;
- la figure 3, déjà décrite, une représentation schématique d'un appareil AP-SALD complet ;
- les figures 4A - 4G, différentes vues d'une tête de dépôt selon un premier mode de réalisation de l'invention ;
- les figures 5A - 5C, deux vues d'une tête de dépôt selon un deuxième mode de réalisation de l'invention, et la figure 5D un détail agrandi de la figure 5B ;
- la figure 6, une représentation simplifiée d'une tête de dépôt selon un quatrième mode de réalisation de l'invention, plus fortement miniaturisée ;
- la figure 7, une représentation simplifiée d'une tête de dépôt selon un cinquième mode de réalisation de l'invention, intégrant des bulleurs ;
- la figure 8, un système de dépôt selon un cinquième mode de réalisation de l'invention ; et
- les figures 9A, 9B et 9C, trois structures semiconductrices pouvant être déposées au moyen de la tête des figures 5A - 5D.

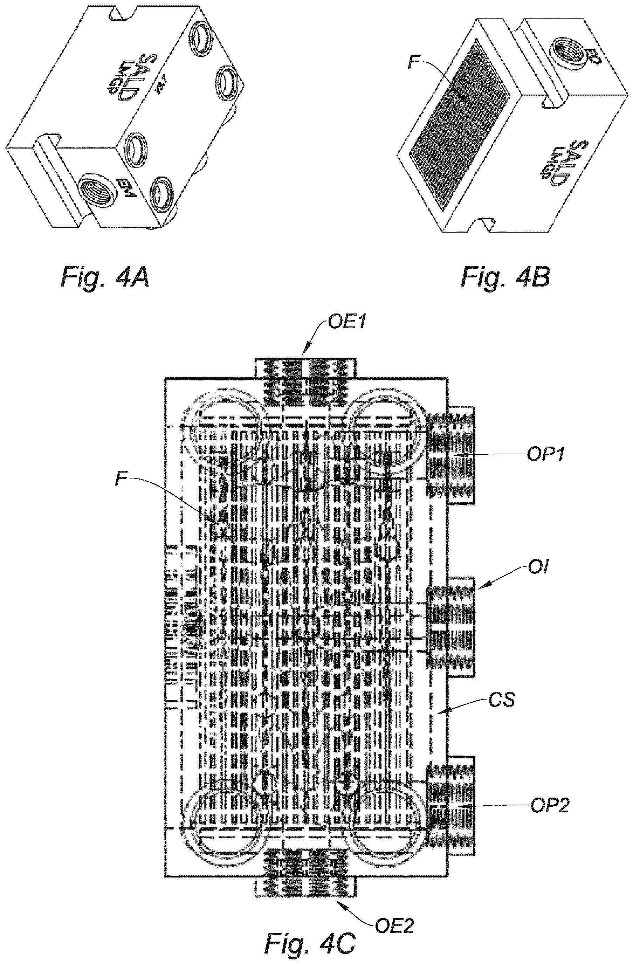

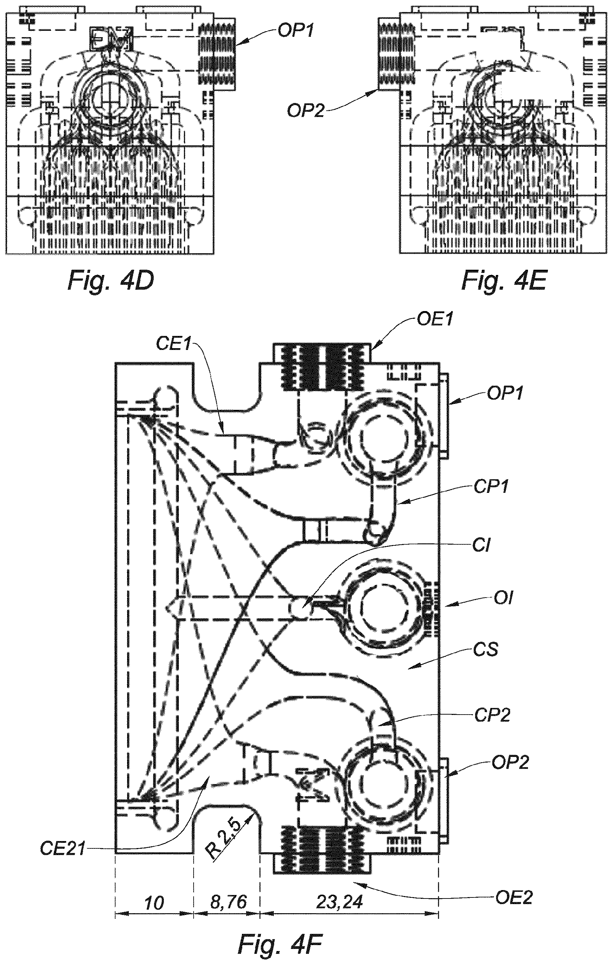

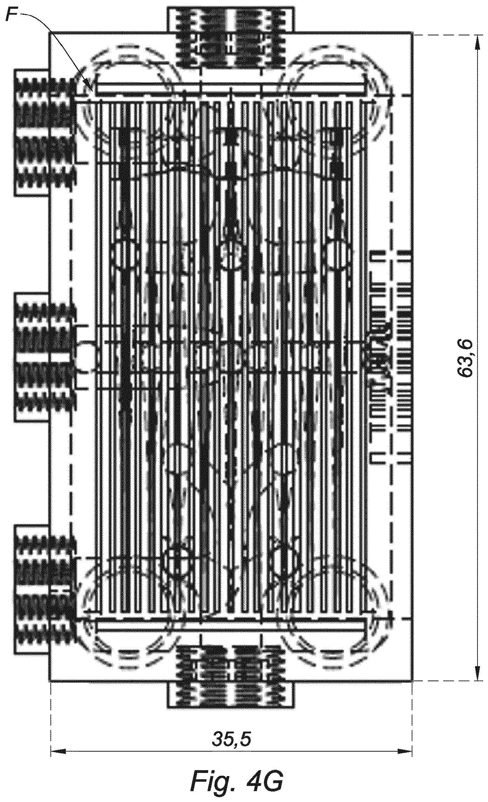

Les figures 4A - 4G sont différentes vues d'une tête de dépôt selon un premier mode de réalisation de l'invention. Ces figures sont à l'échelle, mais l'échelle n'est pas la même d'une figure à l'autre ; certaines portent des côtes en millimètres, données uniquement à titre d'exemple. Les références OP1, OP2, OI, OE1, OE2 représentent, respectivement, les ouvertures reliées aux conduits CP1, CP2, Cl, CE1 (évacuation du gaz contenant le premier précurseur) et CE2 (évacuation du gaz contenant le deuxième précurseur) ; la référence F désigne l'ensemble de fentes réalisées dans la face « inférieure » de la tête.

Contrairement à la tête de dépôt des figures 2A - 2B, celle des figures 4A - 4G est constituée d'une seule pièce, ce qui est rendu possible par sa réalisation par fabrication additive, ou « impression 3D ». Le recours à la fabrication additive permet notamment une plus grande liberté dans la forme des conduits d'amenée et d'évacuation des gaz, qui sont des simples creux ménagés dans le corps solide CS de la tête. Il permet également d'éviter les tâches d'assemblage et soudure, consommatrices de temps et sources de défauts, et d'obtenir une miniaturisation plus poussée des têtes de dépôt.

La tête des figures 4A - 4G peut être métallique, mais également en matériau céramique, voire plastique (polymère). L'utilisation d'une matière plastique n'est possible que dans le cas de précurseurs suffisamment volatiles, ne nécessitant pas d'être amenés à une température élevée, et sous réserve de compatibilité chimique ; elle permet de réduire considérablement les coûts de fabrication.

Plusieurs techniques de fabrication additive peuvent convenir à la réalisation d'une tête de dépôt selon l'invention, en fonction du matériau utilisé. On peut citer, à titre d'exemples non limitatifs, la stéréolithographie et le dépôt de fil fondu pour les matériaux polymères, la fusion sélective par laser pour les matériaux métalliques, le frittage sélectif par laser pour les métaux et les céramiques, mais également certains matériaux polymères, la fusion par faisceau électronique pour certains métaux tel le titane.

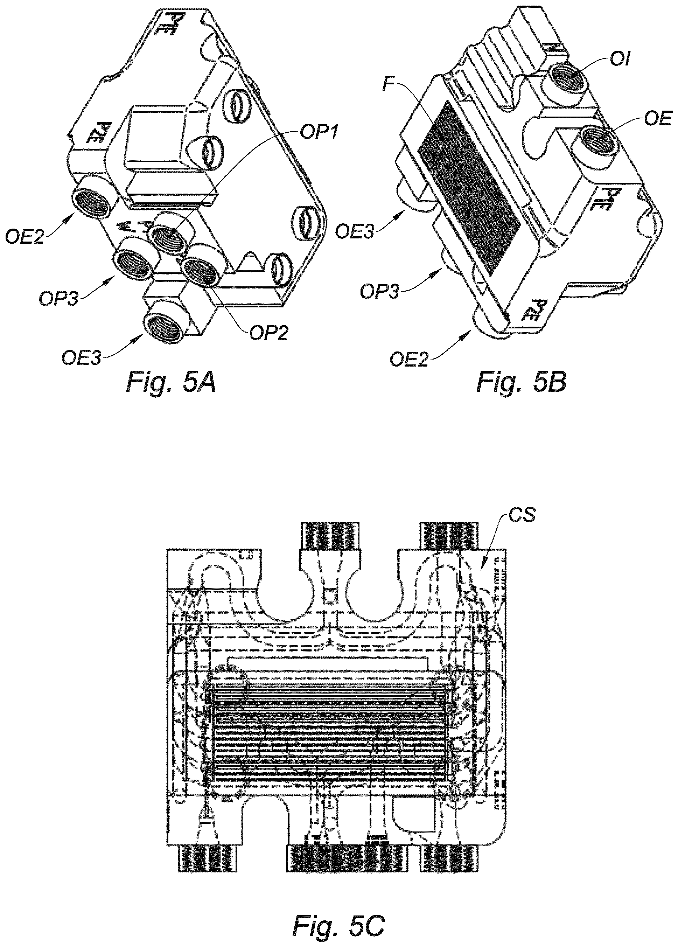

Le recours à des techniques de fabrication additive facilite la réalisation et l'utilisation de têtes de dépôt spécifiquement optimisées pour un processus de dépôt, à son tour spécifiquement conçu pour le dépôt d'une couche ou structure multicouches particulière. Cela est illustré par les figures 5A - 5D. Les figures 5A à 5C sont trois vues d'une autre tête de dépôt, également réalisée d'une seule pièce par fabrication additive, permettant de réaliser un dépôt à partir de trois précurseurs (par exemple deux composés métalliques et de la vapeur d'eau servant d'oxydant). Les références OP1, OP2, OP3, OI, OE1, OE2 représentent, respectivement, les ouvertures d'amenée du premier, deuxième et troisième précurseur et du gaz inerte, et les ouvertures d'évacuation du gaz contenant le premier, le deuxième et le troisième précurseur.

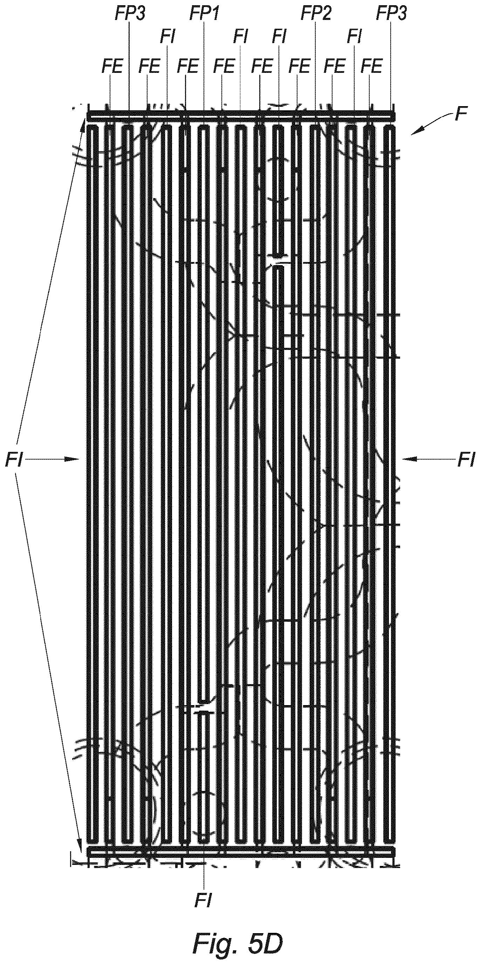

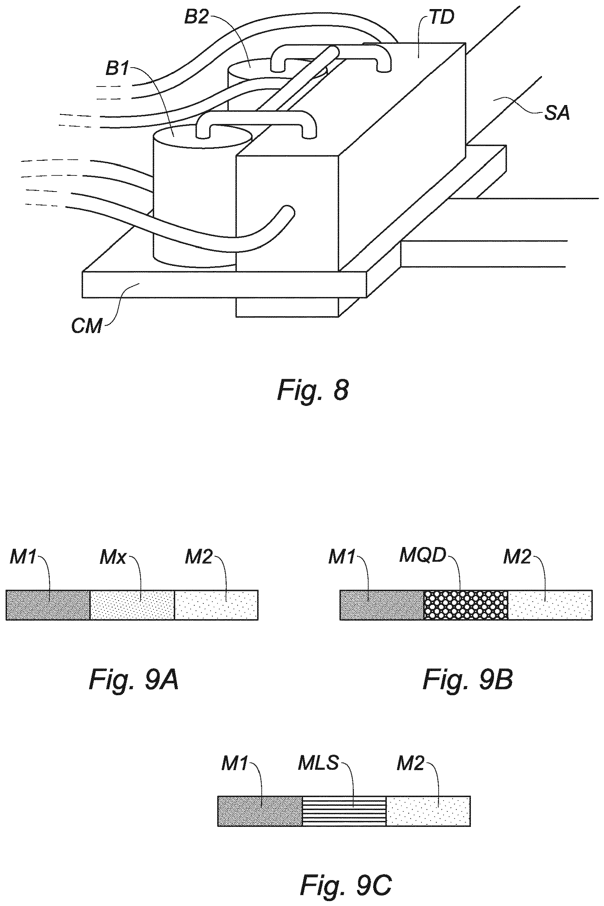

La figure 5D représente plus spécifiquement l'ensemble F de fentes ; cet ensemble comprend des fentes FP1, FP2, FP3, FI, FE1, FE2, FE3 (respectivement, amenée du premier, deuxième et troisième précurseur et du gaz inerte ; évacuation - dans un souci de simplicité, on ne distingue pas parmi les fentes reliées aux différents conduits d'évacuation). Une fente FP1 et une fente FP2 présentent une longueur moindre que celle de l'ensemble, et sont décalées l'une par rapport à l'autre dans le sens de la longueur. Cela permet, par exemple de déposer des structures complexes, dont la composition varie selon une direction spatiale parallèle à l'orientation des lignes. En particulier, cela permet d'obtenir une structure constitué d'une région d'un premier matériau M1 (par exemple, Cu₂O), d'une région d'un deuxième matériau M2 (par exemple, ZnO) et, entre les deux, d'une région constituée soit d'un mélange des deux matériaux (figure 9A, référence Mx), soit d'une structure nano composite (par exemple des boîtes quantiques multiples ou des hétérojonctions de masse) des deux matériaux (figure 9B, référence MQD), soit encore d'une structure multicouche des deux matériaux (figure 9C, référence MLS).

Selon une variante préférée de la tête de dépôt des figures 5A - 5D, une fente de dépôt d'oxydant (FP3) - bien évidemment entourée de fentes d'évacuation et d'amenée de gaz inerte, selon les principes exposés plus haut - est également prévue entre les fentes FP1 et FP2. Cela n'est cependant pas essentiel.

On remarquera que, dans le système de fentes de la figure 5D (mais cela est également vrai pour la tête de dépôt des figures 4A - 4G, les fentes d'amenée du gaz inerte, FI, forment un cadre autour des autres fentes. Deux fentes FI sont orientées perpendiculairement par rapport à la direction de toutes les autres fentes, et deux autres fentes FI viennent prolonger les fentes FP1, FP2 qui, comme cela a été dit plus haut, sont plus courtes. Cela permet d'assurer que les précurseurs ne viennent pas en contact avec l'air ambiant.

On remarquera également que le système de fentes F de la figure 5D comprend des fentes d'évacuation FE1 reliées à l'ouverture OE1 et des fentes d'évacuation FE2 reliées à l'ouverture OE2.

Jusqu'ici, seul des cas où les fentes sont continues, rectilignes et parallèles entre elles (à l'exception de deux fentes FI « fermant les extrémités » de la tête, qui sont perpendiculaires aux autres). Cela n'est cependant pas essentiel : les fentes peuvent ne pas être strictement parallèles et/ou ne pas être rectilignes. Elles peuvent d'ailleurs être discontinues, par exemple constituées de plusieurs petit orifices alignés et rapprochés. D'une manière générale on entend par fente un orifice, ou ensemble orifices reliés entre eux, présentant une largeur très supérieure (au moins d'un facteur 10) à sa largeur. Dans certains cas, les gaz peuvent être amenés et/ou évacués par des orifices dont au moins certains ne peuvent pas être considérés des fentes au sens propre.

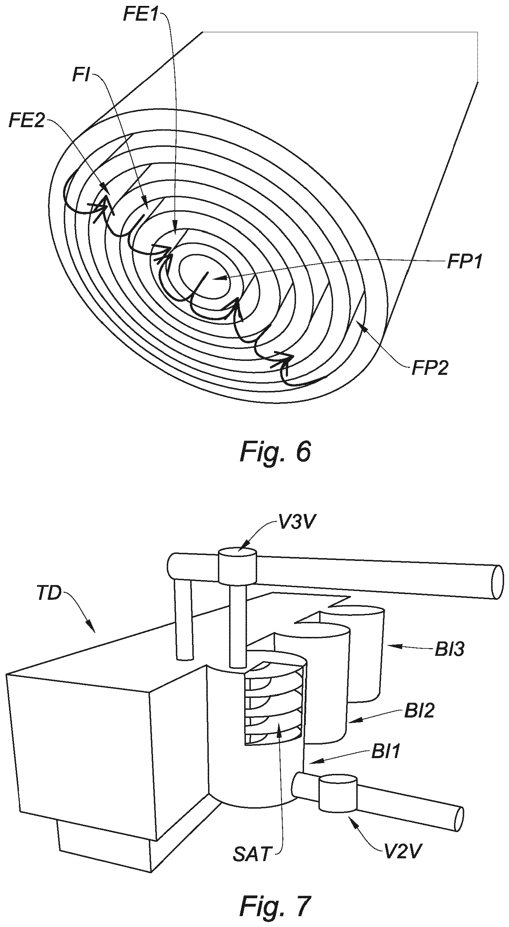

Par exemple, la figure 6 illustre une tête de dépôt selon un mode de réalisation alternatif présentant une structure tubulaire, dans laquelle les fentes FE1, FI, FE2, FP2 forment de cercles (plus généralement, des courbes fermées) concentriques autour d'un orifice central FP1 qui ne constitue pas à proprement parler une fente. Ce mode de réalisation permet de pousser particulièrement loin la miniaturisation de la tête de dépôt, jusqu'à la réalisation de ce qu'on pourrait appeler un « stylo » CVD/ALD.

La fabrication additive peut également être utilisée pour fabriquer les bulleurs, qui peuvent d'ailleurs être intégrés à la tête de dépôt. La figure 7 illustre à ce propos un ensemble formé par une tête de dépôt, par exemple semblable à celle des figures 4A - 4G ou des figures 5A - 5D et trois bulleurs intégrés BI1, BI2, BI3. Dans ce mode de réalisation, le bulleur intégré BI1 est un bulleur « au sens propre », c'est-à-dire destiné à être rempli d'un précurseur à l'état liquide et comportant un conduit de gaz en entrée dans sa partie basse et un conduit de gaz en sortie dans sa partie haute, de telle sorte que le gaz barbouille dans le liquide avant de sortir du bulleur pour être injecté dans la tête. Les conduits d'entrée et de sortie de gaz peuvent également être réalisés par fabrication additive, et être intégrés à la structure. On remarque une vanne à deux voies V2V à l'entrée du premier bulleur et une vanne à trois voies V3V à l'intersection entre le conduit sortant du premier bulleur et le conduit de dilution.

Le bulleur BI1 comporte par ailleurs une structure SAT, par exemple en forme d'hélice, adaptée pour allonger le trajet des bulles à l'intérieur du liquide de façon à faciliter/assurer la saturation du gaz avec des molécules du précurseur. La forme en hélice n'est pas essentielle, la structure SAT pourrait par exemple être en forme de chicane, ou une structure poreuse ou réticulaire (qui fait les bulles plus petites). Les éléments BI2 et BI3 peuvent ne pas être des bulleurs au sens propres, mais plus simplement des réservoirs comportant un tuyau d'injection de gaz et un tuyau d'évacuation (non représentés), qui ne sont pas nécessairement agencés de manière à permettre un barbotement ; le précurseur peut d'ailleurs être solide, par exemple en poudre, du moment qu'il est suffisamment volatile. Les bulleurs, ou certains d'entre eux, peuvent également comporter des éléments de chauffage, par exemple des résistances électriques ou des serpentins pour un liquide chauffé, qui peuvent le cas échéant être réalisés de manière intégrée par fabrication additive.

Selon un autre mode de réalisation les réservoirs et bulleurs peuvent être réalisés par fabrication additive, mais ne pas être intégrés à la tête. Dans ce cas, la tête comprend de préférence une plage d'accueil permettant un montage rapide des réservoirs, par exemple par pression, qui sont ainsi interchangeables. Ces réservoirs peuvent par ailleurs être pré-remplis de précurseur, à la manière des cartouches d'encre des imprimantes.

Qu'ils soient intégrés ou pas, les réservoirs/bulleurs réalisés par fabrication additive présentent typiquement une contenance inférieure à 10 ml, par exemple comprise entre 1 et 2 ml. Il existe dans le commerce des vannes électriques suffisamment petites pour être compatibles avec de tels réservoirs.

La miniaturisation rendue possible par l'utilisation de techniques de fabrication additive permet ainsi de rapprocher les réservoirs de la tête d'impression. En raison des faibles volumes en jeu, cela n'est pas dangereux même en présence de précurseurs inflammables. Comme cela a été expliqué plus haut, cela permet de réduire le gaspillage de précurseurs, de réduire sensiblement la durée des phases de purge et de réduire les risques de contamination. Cela permet aussi de modifier d'une manière plus radicale la structure et le fonctionnement d'un système de dépôt AP-SALD en montant l'ensemble formé par la tête de dépôt TD et des réservoirs/bulleurs B1, B2 (intégrés ou pas) sur un chariot CM pouvant se déplacer au-dessus d'un substrat qui est maintenu stationnaire - contrairement au mode de fonctionnement du système conventionnel décrit plus haut en référence à la figure 1. Un tel système est illustré schématiquement sur la figure 8. L'ensemble mobile CM/TD/B1/B2 est relié à un bâti non représenté par l'intermédiaire d'un système d'actionnement SA, comprenant typiquement des moteurs électriques permettent un déplacement du chariot en une, deux ou trois dimensions (ainsi, le cas échéant, que son orientation selon un, deux ou trois axes) et par deux ou trois tuyaux flexibles - un tuyau d'amenée de gaz et un ou deux tuyaux d'évacuation. Les vannes à deux et à trois voies ne sont pas représentées pour ne pas alourdir la figure.

Le mode de réalisation de la figure 6 s'avère particulièrement avantageux lorsque la tête de dépôt se déplace sur le substrat. En effet, sa forme circulaire permet d'effectuer le dépôt quelle que soit la direction du déplacement du chariot, sans besoin de tourner la tête pour que les fentes restent perpendiculaires à cette direction de déplacement.

L'invention est particulièrement adaptée au dépôt sélectif de type SALD. Comme indiqué précédemment, une tête de dépôt telle que représentée sur les figures 5A à 5D permet un dépôt spatialement sélectif en adaptant la longueur des fentes. De même la tête représentée sur la figure 6 est également adaptée au dépôt sélectif. Cette tête peut être miniaturisée et la sélection spatiale des zones de dépôt se fait alors en déplaçant un chariot sur lequel la tête est montée.

L'invention a été décrite en référence à son application à la technique AP-SALD, cependant elle peut également convenir à la mise en œuvre d'autres procédés de type CVD.

## Revendications

1. Tête de dépôt (TD) chimique en phase vapeur comprenant un corps solide (CS) comportant :
- au moins une première ouverture (OP1) pour recevoir un premier flux gazeux en entrée transportant un premier précurseur, une deuxième ouverture (OP2) pour recevoir un deuxième flux gazeux en entrée transportant un deuxième précurseur, une troisième ouverture (OI) pour recevoir un troisième flux gazeux inerte en entrée et une quatrième ouverture d'évacuation d'un quatrième flux gazeux ;
- une face de sortie portant une pluralité (F) d'orifices (FP1, FP2, FI, FE1, FE2) ; et
- un réseau de conduits de distribution (CP1, CP2, Cl CE1, CE2), ménagé à l'intérieur du corps solide, reliant chaque ouverture à au moins un desdits orifices ;
dans laquelle chaque orifice relié à la première ouverture est séparé du ou de chaque plus proche orifice relié à la deuxième ouverture par au moins un orifice relié à la troisième ouverture et par deux orifice reliés à la quatrième ouverture, agencés de part et d'autre de l'orifice relié à la troisième ouverture ;
**caractérisée en ce que** le corps solide est réalisé en une seule pièce par fabrication additive, le réseau de conduits de distribution étant formé par des cavités ménagées dans ladite pièce ;
et **en ce que** la tête de dépôt comprend également au moins un premier et un deuxième réservoir (B1, B2 ; BI1, BI2, BI3), reliés respectivement à la première et à la deuxième ouverture par des conduits de sortie respectifs, chaque dit réservoir comprenant un volume creux susceptible de contenir un précurseur à l'état liquide ou solide (PL1, PL2) et un conduit d'entrée agencé de telle sorte qu'un flux gazeux injecté dans le conduit d'entrée entre en contact avec le précurseur avant de parvenir au conduit de sortie respectif, le premier et le deuxième réservoirs, ainsi que les conduits d'entrée et de sortie, étant réalisés d'une seule pièce avec le corps solide par fabrication additive.

2. Tête de dépôt selon la revendication 1 dans laquelle les orifices sont des fentes rectilignes et parallèles entre elles.

3. Tête de dépôt selon la revendication 2 dans laquelle au moins une fente reliée à la première et au moins une fente reliée à la deuxième ouverture présentent une longueur moindre que les fentes reliées à la troisième et à la quatrième ouverture et sont décalées l'une par rapport à l'autre dans le sens de la longueur.

4. Tête de dépôt selon la revendication 1 dans laquelle les orifices forment des courbes fermées concentriques, et préférentiellement des cercles concentriques.

5. Tête de dépôt selon l'une des revendications précédentes dans lequel au moins un dit réservoir est un bulleur (BI1) dont le volume creux est destiné à contenir un précurseur à l'état liquide, le conduit d'entrée et le conduit de sortie étant agencés de telle sorte que le flux gazeux injecté dans le conduit d'entrée barbote à travers le liquide avant de parvenir au conduit de sortie.

6. Tête de dépôt selon la revendication 5 dans lequel le volume creux de chaque bulleur contient une structure (SAT) configurée pour allonger le trajet parcouru par des bulles de gaz entre le conduit d'entrée et le conduit de sortie.

7. Système de dépôt en phase vapeur comprenant une tête (TD) selon l'une des revendications précédentes et un chariot (CM) portant ladite tête et permettant de la déplacer au-dessus d'un substrat.

8. Procédé de dépôt d'au moins une couche mince (CD), ou d'un dispositif à couches minces, sur un substrat comprenant :
- la conception d'un processus de dépôt en phase vapeur adapté à la réalisation de ladite couche ou dudit dispositif ;
- la conception d'une tête de dépôt (TD) selon l'une des revendications précédentes, spécialement adaptée à la mise en œuvre d'un tel processus ;
- la réalisation de ladite tête de dépôt par fabrication additive ; et
- l'utilisation de ladite tête pour la mise en œuvre dudit processus.

9. Procédé selon la revendication 8 dans lequel ledit processus de dépôt est effectué de manière spatialement sélective sur le substrat.

## Patentansprüche

1. Kopf zur chemischen Dampfphasenabscheidung (TD) umfassend einen Festkörper (CS), der Folgendes aufweist:
- mindestens eine erste Öffnung (OP1) zur Aufnahme eines ersten Eingangsgasstroms, der einen ersten Vorläufer transportiert, eine zweite Öffnung (OP2) zur Aufnahme eines zweiten Eingangsgasstroms, der einen zweiten Vorläufer transportiert, eine dritte Öffnung (OI) zur Aufnahme eines dritten Eingangsinertgasstroms und eine vierte Öffnung zum Ablassen eines vierten Gasstroms;
- eine Ausgangsseite, die eine Vielzahl (F) von Löchern (FP1, FP2, FI, FE1, FE2) trägt; und
- ein Netzwerk von Verteilungskanälen (CP1, CP2, CI CE1, CE2), die innerhalb des Festkörpers gebildet sind und jede Öffnung mit mindestens einem der Löcher verbinden;
wobei jedes mit der ersten Öffnung verbundene Loch von dem oder jedem nächsten mit der zweiten Öffnung verbundenen Loch durch mindestens ein mit der dritten Öffnung verbundenes Loch und durch zwei mit der vierten Öffnung verbundene Löcher getrennt ist, die auf beiden Seiten des mit der dritten Öffnung verbundenen Lochs angeordnet sind;
**dadurch gekennzeichnet, dass** der Festkörper in einem einzigen Stück durch additive Fertigung hergestellt wird, wobei das Netz von Verteilungsleitungen durch Hohlräume in dem Stück gebildet wird;
und dadurch, dass der Abscheidungskopf auch mindestens ein erstes und ein zweites Reservoir (B1, B2 ; BI1, BI2, BI3), die mit der ersten bzw. zweiten Öffnung durch jeweilige Ausgangskanäle verbunden sind, umfasst, wobei jedes Reservoir ein Hohlvolumen, das einen flüssigen oder festen Vorläufer (PL1, PL2) enthalten kann, und eine Eingangsleitung umfasst, die so angeordnet ist, dass ein in die Eingangsleitung eingespritzter Gasstrom mit dem Vorläufer in Kontakt kommt, bevor er die jeweilige Ausgangsleitung erreicht, wobei das erste und das zweite Reservoir sowie die Ein- und die Ausgangsleitung durch additive Fertigung einstückig mit dem Festkörper hergestellt werden.

2. Abscheidungskopf nach Anspruch 1, wobei die Löcher geradlinige und parallel zueinander verlaufende Schlitze sind.

3. Abscheidungskopf nach Anspruch 2, wobei mindestens ein mit der ersten Öffnung verbundener Schlitz und mindestens ein mit der zweiten Öffnung verbundener Schlitz eine geringere Länge haben als die mit der dritten und vierten Öffnung verbundenen Schlitze und in Längsrichtung gegeneinander versetzt sind.

4. Abscheidungskopf nach Anspruch 1, wobei die Löcher konzentrische geschlossene Kurven und vorzugsweise konzentrische Kreise bilden.

5. Abscheidungskopf nach einem der vorherigen Ansprüche, wobei mindestens eines der Reservoire ein Bubbler (BI1) ist, dessen Hohlraum zum Fassen eines Vorläufers im flüssigen Zustand bestimmt ist, wobei die Eingangsleitung und die Ausgangsleitung so angeordnet sind, dass der in die Eingangsleitung eingespritzte Gasstrom durch die Flüssigkeit perlt, bevor er die Ausgangsleitung erreicht.

6. Abscheidungskopf nach Anspruch 5, wobei der Hohlraum jedes Bubblers eine Struktur (SAT) enthält, die zum Verlängern des Wegs der Gasblasen zwischen der Eingangsleitung und der Ausgangsleitung konfiguriert ist.

7. Dampfabscheidungssystem umfassend einen Kopf (TD) nach einem der vorherigen Ansprüche und einem Schlitten (CM), der den Kopf trägt und seine Bewegung über ein Substrat ermöglicht.

8. Verfahren zum Abscheiden von mindestens einer Dünnschicht (CD) oder einer Dünnschichtvorrichtung auf einem Substrat, das Folgendes umfasst:
- Konzipieren eines Dampfphasenabscheidungsprozesses, der für die Herstellung der Schicht oder der Vorrichtung geeignet ist;
- Konzipieren eines Abscheidungskopfs (TD) nach einem der vorherigen Ansprüche, der speziell für die Umsetzung eines solchen Prozesses geeignet ist;
- Herstellen des Abscheidungskopfs durch additive Fertigung; und
- Verwenden des Kopfs zur Umsetzung des Prozesses.

9. Verfahren nach Anspruch 8, wobei der Abscheidungsprozess räumlich selektiv auf dem Substrat durchgeführt wird.

## Claims

1. A chemical vapour deposition head (TD) comprising a solid body (CS) having:
- at least a first opening (OP1) for receiving a first input gas flow conveying a first precursor, a second opening (OP2) for receiving a second input gas flow conveying a second precursor, a third opening (OI) for receiving a third input inert gas flow and a fourth opening for discharging a fourth gas flow;
- an output face bearing a plurality (F) of orifices (FP1, FP2, FI, FE1, FE2); and
- a network of distribution ducts (CP1, CP2, CI, CE1, CE2), formed inside the solid body, linking each opening to at least one of said orifices;
wherein each orifice linked to the first opening is separated from the or each closest orifice linked to the second opening by at least one orifice linked to the third opening and by two orifices linked to the fourth opening, arranged on either side of the orifice linked to the third opening;
**characterised in that** the solid body is produced in a single piece by additive manufacturing, the network of distribution ducts being formed by cavities formed in said piece
and **in that** the deposition head also comprises at least one first reservoir and one second reservoir (B1, B2; BI1, BI2, BI3), linked respectively to the first and to the second opening by respective output ducts, each said reservoir comprising a hollow volume capable of containing a precursor in the liquid or solid state (PL1, PL2) and an input duct arranged so that a gas flow injected into the input duct enters into contact with the precursor before arriving at the respective output duct, the first and the second reservoirs, and the input and output ducts, being produced in a single piece with the solid body by additive manufacturing.

2. The deposition head according to claim 1, wherein the orifices are rectilinear and mutually parallel slits.

3. The deposition head according to claim 2, wherein at least one slit linked to the first opening and at least one slit linked to the second opening have a shorter length than the slits linked to the third opening and to the fourth opening and are offset lengthwise with respect to one another.

4. The deposition head according to claim 1, wherein the orifices form concentric closed curves, and preferentially concentric circles.

5. The deposition head according to one of the preceding claims, wherein at least one said reservoir is a bubbler (BI1) whose hollow volume is intended to contain a precursor in the liquid state, the input duct and the output duct being arranged so that the gas flow injected into the input duct bubbles through the liquid before arriving at the output duct.

6. The deposition head according to claim 5, wherein the hollow volume of each bubbler contains a structure (SAT) configured to lengthen the path travelled by gas bubbles between the input duct and the output duct.

7. A vapour deposition system comprising a head (TD) according to one of the preceding claims and a carriage (CM) bearing said head and allowing it to be moved over a substrate.

8. A method for depositing at least one thin layer (CD), or a thin-layered device, on a substrate comprising:
- the design of a vapour deposition process suitable for producing said layer or said device;
- the design of a deposition head (TD) according to the preceding claims, specially adapted to implement such a process;
- the production of said deposition head by additive manufacturing; and
- the use of said head to implement said process.

9. The method according to claim 8, wherein said deposition process is performed spatially selectively on the substrate.
